# EUROPEAN PATENT APPLICATION

(11) **EP 4 408 132 A1**
(43) Date of publication of application: **31.07.2024**
(21) Application number: 22876838.8
(22) Date of filing: 28.09.2022
(51) Int. Cl.: H05K 1/14, H05K 1/11, H05K 9/00, H04M 1/02

(54) **PRINTED CIRCUIT BOARD MODULE AND ELECTRONIC APPARATUS COMPRISING SAME**

(30) Priority: 28.09.2021 KR 20210128129
(71) Applicant: Samsung Electronics Co., Ltd., Suwon-si, Gyeonggi-do 16677 (KR)
(72) Inventor: JEON, Jinhwan, Suwon-si, Gyeonggi-do 16677 (KR)
(74) Representative: HGF
(86) International application number: PCT/KR2022/014546
(87) International publication number: WO 2023/055066

(57) **Abstract**

Various embodiments of the present disclosure relate to a printed circuit board module and an electronic apparatus comprising same. According to various embodiments of the present disclosure, provided is a printed circuit board module comprising: a board including a first surface facing a first direction and having formed thereon a first pad for electrical connection with the board, and a second surface facing a second direction opposite to the first direction and having formed thereon the first pad for electrical connection with the board and a second pad for bonding a shielding member; and at least one component disposed on the second surface, wherein the printed circuit board module may be bonded to an adjacent board by using the first pad formed on the first surface or the second surface. Various other embodiments may be applied.

## Description

### [Technical Field]

Various embodiments of the disclosure relate to a printed circuit board module and an electronic device including the same.

### [Background Art]

Recently, electronic devices such as portable terminals having novel functions have been developed at a rapid pace, and as the distribution of the electronic devices has expanded, the proportion of the electronic devices in peoples' lives is gradually increasing.

In addition, with respect to portable terminals such as smartphones, which have become popularized due to the development of mobile communication technology, demand for miniaturization and weight reduction is increasing in order to maximize the portability and convenience of users, and integrated electrical components are being mounted in spaces that are gradually becoming smaller, in order to achieve high performance. According to an embodiment, a main printed circuit board provided in an electronic device may be provided connection member in which several components are intensively assembled, for example, in the form of a printed circuit board assembly (PBA).

In an electronic device according to some embodiments, a main printed circuit board (hereinafter, referred to as, e.g., a "PBA") may have a shape extending in the longitudinal direction of the electronic device (e.g., an "I" shape). In addition, adjacent to the PBA, components such as a battery, a camera module, and an audio module may be placed on the same plane as the PBA. In the case in which the components such as a battery, a camera module, and an audio module are disposed on the same plane as the PBA, as the size of the PBA increases, there may be a limitation in securing a mounting space for the components. Therefore, in implementing various functions in a single electronic device, it is required to reduce the size of the PBA. As an example, a half printed circuit board (half PCB) structure may be adopted in order to mount a larger capacity battery in the electronic device. According to an embodiment, a half printed circuit board (half PCB) structure may include a PBA that may have a size corresponding to about half or less of the size of a display.

### [Detailed Description of the Invention]

### [Technical Problem]

Along with this trend of miniaturization of the size of a PBA, the issue of commonization of a PBA is also raised. Here, the "commonization of a PBA" may mean that circuits and components that provide a solution are manufactured to be compatible with various types of electronic devices. By modularizing and simplifying major components provided in electronic devices through the commonization of a PBA, it is possible to sufficiently secure a mounting space inside an electronic device and to reduce the cost of an electronic device manufacturing process.

According to an embodiment, the commonization of a PBA may be implemented based on packaging of components. For example, a PBA may include one or more boards, and a plurality of components may be disposed on at least one surface of the one or more boards. In addition, the plurality of components may be packaged in a form of being surrounded by a single shielding member (e.g., a shield can).

According to some embodiments, in packaging a plurality of components, a stacked PCB structure may be adopted. The stacked PCB structure may be a structure in which a plurality of components included in a PBA are disposed separately on different layers. Application of the stacked PCB structure may contribute to the reduction of the area of the PBA, but may increase the height (or thickness) of the PBA.

Accordingly, a stacked PCB structure may be applied to reduce the size of a PBA while commonizing the PBA, but another problem of lowering the height thereof may be raised.

Accordingly, various embodiments of the disclosure are intended to provide a PBA structure that is capable of reducing the area as well as the height of a PBA while achieving the purpose of commonization of the PBA.

However, the problems to be solved in the disclosure are not limited to the above-mentioned problems, and may be variously expanded without departing from the spirit and scope of the disclosure.

### [Technical Solution]

According to various embodiments of the disclosure, it is possible to provide a printed circuit board module including: a board that includes: a first surface oriented in a first direction and provided with a first pad for electrical connection with another board; and a second surface oriented in a second direction opposite to the first direction and provided with a first pad for electrical connection with the another board and a second pad to which a shielding member is to be bonded; and at least one component disposed on the second surface, wherein the printed circuit board module is capable of being bonded to the another board disposed adjacent thereto by using the first pad provided on the first surface or the second surface.

According to various embodiments of the disclosure, it is possible to provide an electronic device including: a housing; a board disposed inside the housing and including at least one opening; and a printed circuit board module including a first surface and a second surface which faces away from the first surface, the printed circuit board module being disposed on the board in a state of being at least partially accommodated in the opening, wherein the printed circuit module is provided with pads on the first surface and the second surface such that the printed circuit board module is capable of being selectively bonded to the board via the first surface or the second surface.

### [Advantageous Effects]

According to various embodiments of the disclosure, it is possible to achieve commonization of a printed circuit board module, so that a communal module can be used in various electronic devices. Accordingly, it is possible to reduce a manufacturing cost of the electronic devices.

According to various embodiments of the disclosure, it is possible to secure a component mounting space inside an electronic device by reducing an area as well as a height of a printed circuit board module.

### [Brief Description of Drawings]

FIG. 1 is a block diagram of an electronic device according to various embodiments in a network environment.
FIG. 2 is a front perspective view illustrating an electronic device according to various embodiments of the disclosure.
FIG. 3 is a rear perspective view illustrating the electronic device according to various embodiments of the disclosure.
FIG. 4 is a view illustrating an arrangement relationship of a plurality of components inside an electronic device according to various embodiments of the disclosure.
FIG. 5 is a view illustrating a printed circuit board assembly according to some embodiments.
FIG. 6 is a view illustrating a printed circuit board to which a communal printed circuit board module according to various embodiments of the disclosure is applied.
FIG. 7 is a view illustrating a printed circuit board assembly including at least one printed circuit board module according to an embodiment of the disclosure.
FIG. 8 is a view illustrating a printed circuit board assembly including at least one printed circuit board module according to another embodiment of the disclosure.
FIG. 9 is a view illustrating a printed circuit board assembly including at least one printed circuit board module according to still another embodiment of the disclosure.
FIG. 10A is a view illustrating a first surface of a printed circuit board module according to various embodiments of the disclosure.
FIG. 10B is a view illustrating a second surface of a printed circuit board module according to various embodiments of the disclosure.
FIG. 11 is a view illustrating a third pad, a fourth pad, and a fifth pad provided on the second surface of the printed circuit board module according to various embodiments of the disclosure.
FIGS. 12A and 12B are views each illustrating a paste metal according to various embodiments of the disclosure.
FIG. 13 is a view illustrating a printed circuit board module according to another embodiment of the disclosure.
FIG. 14 is a view illustrating a board of an electronic device according to another embodiment.
FIG. 15 is a view illustrating a state in which a communal printed circuit board module is disposed on a board of an electronic device according to another embodiment.
FIG. 16A is a view illustrating a method of disposing a communal printed circuit board module in an opening, according to an embodiment.
FIG. 16B is a view illustrating a method of disposing a communal printed circuit board module in an opening, according to an embodiment different from that of FIG. 16A.

### [Mode for Carrying out the Invention]

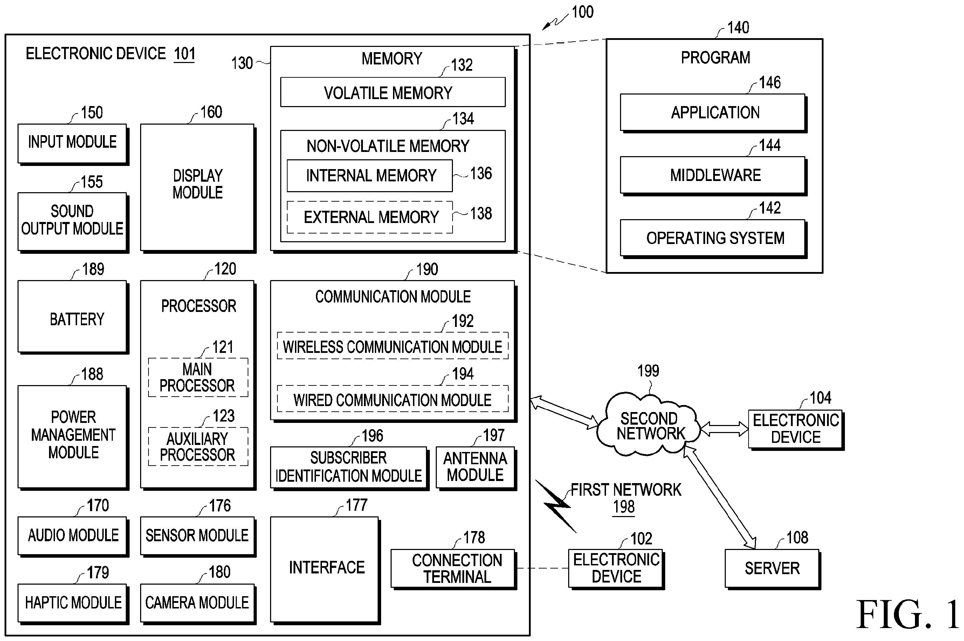

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160). The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

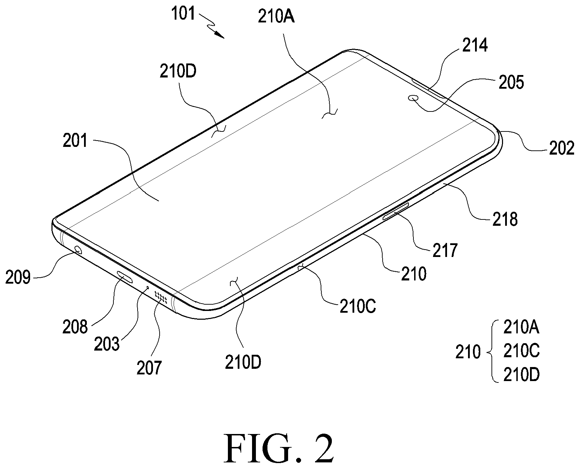

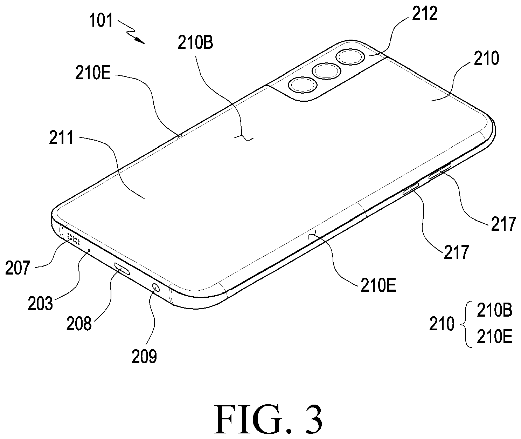

FIG. 2 is a front perspective view illustrating an electronic device according to various embodiments of the disclosure. FIG. 3 is a rear perspective view illustrating the electronic device according to various embodiments of the disclosure.

Referring to FIGS. 2 and 3, an electronic device 101 according to an embodiment may include a housing 210 including a front surface 210A, a rear surface 210B, and a side surface 210C surrounding a space between the front surface 210A and the rear surface 210B. In another embodiment (not illustrated), the housing 210 may refer to a structure defining a part of the front surface 210A in FIG. 2, the rear surface 210B, and the side surface 210C in FIG. 3. According an embodiment, at least a portion of the front surface 210A may be provided by a substantially transparent front plate 202 (e.g., a glass plate or a polymer plate including various coating layers). The rear surface 210B may be defined by the rear plate 211. The rear plate 211 may be formed of, for example, glass, ceramic, a polymer, a metal (e.g., aluminum, stainless steel (STS), or magnesium), or a combination of two or more of these materials. The side surface 210C may be provided by a side bezel structure (or a "side member") 218 coupled to the front plate 202 and the rear plate 211 and including a metal and/or a polymer. In some embodiments, the rear plate 211 and the side bezel structure 218 may be integrally configured with each other, and may include the same material (e.g., glass, a metal material such as aluminum, or ceramic).

In the illustrated embodiment, the front plate 202 may include, at the opposite ends of long edges thereof, two first edge areas 210D, which are bent from the front surface 210A toward the rear plate 211 and extend seamlessly. In the illustrated embodiment (see FIG. 3), the rear plate 211 may include, at the opposite ends of long edges thereof, two second edge regions 210E, which are bent from the rear surface 210B toward the front plate 202 and extend seamlessly. In some embodiments, the front plate 202 (or the rear plate 211) may include only one of the first edge regions 210D (or the second edge regions 210E). In another embodiment, some of the first edge regions 210D or the second edge regions 210E may not be included. In the embodiments described above, when viewed from a side of the electronic device 101, the side bezel structure 218 may have a first thickness (or width) on the side surface portions that do not include the first edge regions 210D or the second edge regions 210E described above, and may have a second thickness, which is smaller than the first thickness, on the side surface portions that include the first edge regions 210D or the second edge regions 210E.

According to an embodiment, the electronic device 101 may include at least one of a display device 201, an audio module 203, 207, or 214 (e.g., the audio module 170 in FIG. 1), a sensor module (e.g., the sensor module 176 in FIG. 1), a camera module 205 or 212 (e.g., the camera module 180 in FIG. 1), a key input device 217 (e.g., the input module 150 in FIG. 1), and a connector hole 208 or 209 (e.g., the connection terminal 178 in FIG. 1). In some embodiments, in the electronic device 101, at least one of the components (e.g., the connector hole 209) may be omitted, or other components may be additionally included.

According to an embodiment, the display 201 may be visually exposed through a substantial portion of, for example, the front plate 202. In some embodiments, at least a portion of the display 201 may be exposed through the front plate 202 defining the front surface 210A and the first edge regions 210D. In some embodiments, the edges of the display 201 may be configured to be substantially the same as the shape of the periphery of the front plate 202 adjacent thereto. In another embodiment (not illustrated), the distance between the periphery of the display 201 and the periphery of the front plate 202 may be substantially constant in order to increase the exposed area of the display 201.

According to an embodiment, the surface (or the front plate 202 ) of the housing 210 may include a screen display area provided since the display 201 is visually exposed. For example, the screen display area may include the front surface 210A and the first edge regions 210D.

In another embodiment (not illustrated), a portion of the screen display area (e.g., the front surface 210A and the first edge regions 210D) of the display 201 may be provided with a recess or an opening and may include at least one of an audio module 214, a sensor module (not illustrated), a light-emitting element (not illustrated), and a camera module 205, which are aligned with the recess or the opening. In another embodiment (not illustrated), the rear surface of the screen display area of the display 201 may include at least one of an audio module 214, a sensor module (not illustrated), a camera module 205, a fingerprint sensor (not illustrated), and a light-emitting element (not illustrated).

In another embodiment (not illustrated), the display 201 may be coupled to or disposed adjacent to a touch-sensitive circuit, a pressure sensor capable of measuring a touch intensity (pressure), and/or a digitizer configured to detect a magnetic field-type stylus pen.

In some embodiments, at least some of the key input devices 217 may be disposed in the first edge regions 210D and/or the second edge regions 210E.

According to an embodiment, the audio module 203, 207, or 214 may include a microphone hole 203 and a speaker hole 207 or 214. The microphone hole 203 may include a microphone disposed therein to acquire external sound, and in some embodiments, a plurality of microphones may be disposed therein to be able to detect the direction of sound. The speaker hole 207 or 214 may include an external speaker hole 207 and a call receiver hole 214. In some embodiments, the speaker hole 207 or 214 and the microphone hole 203 may be implemented as a single hole, or a speaker may be included without the speaker hole 207 or 214 (e.g., a piezo speaker). The audio module 203, 207, or 214 is not limited to the above-described structure, and various design changes such as mounting only some audio modules and adding new audio modules may be made depending on the structure of the electronic device 101.

According to an embodiment, sensor modules (not illustrated) may generate an electrical signal or a data value corresponding to, for example, an internal operating state of the electronic device 101 or an external environmental state. The sensor modules (not illustrated) may include, for example, a first sensor module (not illustrated) (e.g., a proximity sensor) and/or a second sensor module (not illustrated) (e.g., a fingerprint sensor) disposed on the front surface 210A of the housing 210, and/or a third sensor module (not illustrated) (e.g., an HRM sensor) and/or a fourth sensor module (not illustrated) (e.g., a fingerprint sensor) disposed on the rear surface 210B of the housing 210. In some embodiments (not illustrated), the fingerprint sensor may be disposed not only on the front surface 210A (e.g., the display 201) of the housing 210, but also on the rear surface 210B. The electronic device 101 may further include at least one of sensor modules (not illustrated in the drawings), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor (not illustrated). The sensor modules (not illustrated) are not limited to the above-described structure, and various design changes such as mounting only some of the sensor modules and adding new sensor modules may be made depending on the structure of the electronic device 101.

According to an embodiment, the camera modules 205 and 212 may include, for example, a front camera module 205 disposed on the front surface 210A of the electronic device 101, a rear camera module 212 disposed on the rear surface 210B, and/or a flash (not illustrated). The camera modules 205 and 212 may include one or more lenses, an image sensor, and/or an image signal processor. The flash (not illustrated) may include, for example, a light-emitting diode or a xenon lamp. In some embodiments, two or more lenses (e.g., an infrared camera, a wide-angle lens, and a telephoto lens), and image sensors may be disposed on one surface of the electronic device 101. The camera modules 205 and 212 are not limited to the above-described structure, and various design changes such as mounting only some of the camera modules and adding new camera modules may be made depending on the structure of the electronic device 101.

According to an embodiment, the electronic device 101 may include a plurality of camera modules (e.g., a dual camera or a triple camera) having different properties (e.g., angles of view) or functions, respectively. For example, a plurality of camera modules 205 and 212 including lenses having different angles of view may be configured, and the electronic device 101 may control the change of the angles of view of the camera modules 205 and 212 executed therein based on a user's selection. For example, at least one of the plurality of camera modules 205 and 212 may be a wide-angle camera, and at least one of other camera modules may be a telephoto camera. Similarly, at least one of the plurality of camera modules 205 and 212 may be a front camera, and at least one of other camera modules may be a rear camera. In addition, the plurality of camera modules 205 and 212 may include at least one of a wide-angle camera, a telephoto camera, or an infrared (IR) camera (e.g., a time-of-flight (TOF) camera, or a structured light camera). According to an embodiment, the IR camera may be operated as at least a part of a sensor module. For example, the TOF camera may be operated as at least a part of a sensor module (not illustrated) for detecting a distance to a subject.

According to an embodiment, the key input devices 217 may be disposed on the side surface 210C of the housing 210. In another embodiment, the electronic device 101 may not include some or all of the above-mentioned key input devices 217, and a key input device 217, which is not included in the above-mentioned key input devices, may be implemented in another type, such as a soft key, on the display 201. In some embodiments, a key input device may include a sensor module (not illustrated) disposed on the rear surface 210B of the housing 210.

According to an embodiment, the light-emitting element (not illustrated) may be disposed on, for example, the front surface 210A of the housing 210. The light-emitting element (not illustrated) may provide, for example, information about the state of the electronic device 101 in an optical form. In another embodiment, the light-emitting element (not illustrated) may provide a light source that is interlocked with, for example, the operation of the front camera module 205. The light-emitting element (not illustrated) may include, for example, an LED, an IR LED, and/or a xenon lamp.

According to an embodiment, the connector holes 208 and 209 may include, for example, a first connector hole 208 capable of accommodating a connector (e.g., a USB connector) for transmitting/receiving power and/or data to/from an external electronic device, and/or a second connector hole 209 capable of accommodating a connector (e.g., an earphone jack) for transmitting/receiving an audio signal to/from an external electronic device. The connector holes 208 and 209 are not limited to the above-described structure, and various design changes such as providing only some of the connector holes and adding new connector holes may be made depending on the structure of the electronic device 101.

According to an embodiment, the camera modules 205 and/or the sensor modules (not illustrated) may be disposed in the internal space of the electronic device 101 to come into contact with the external environment through a predetermined region of the display 301 and the front plate 202. For example, the predetermined region may be the region in which no pixels are not disposed in the display 201. As another example, the predetermined region may be a region in which pixels are disposed in the display 201. When viewed from above of the display 201, at least a portion of the predetermined region may overlap the camera module 205 and/or a sensor module. As another embodiment, some sensor modules may be arranged in the internal space of the electronic device to implement the functions thereof without being visually exposed through the front plate 202.

Although the electronic device 101 illustrated in FIGS. 2 and 3 has a bar-type or plate-type appearance, the disclosure is not limited thereto. For example, the illustrated electronic device may be a part of a rollable electronic device or a foldable electronic device. The term "rollable electronic device" may mean an electronic device in which bending deformation of a display (e.g., the display 201) is possible so that at least a portion of the display capable of being wound or rolled or capable of being accommodated in the inside of the housing (e.g., the housing 210 in FIG. 2). According to a user's need, the rollable electronic device may be used in the state in which the screen display region is expanded by unfolding the display or exposing a larger area of the display to the outside. A "foldable electronic device" may mean an electronic device in which two different regions of the display are foldable to face each other or to be oriented in directions opposite to each other. In general, in the foldable electronic device in a portable state, the display is folded in the state in which two different regions face each other or in opposite directions, and in actual use, the user may unfold the display such that the two different regions form a substantially flat plate shape. In some embodiments, the electronic device 101 according to various embodiments disclosed herein may be interpreted as including not only a portable electronic device such as a smartphone, but also various other electronic devices such as a notebook computer or a home appliance.

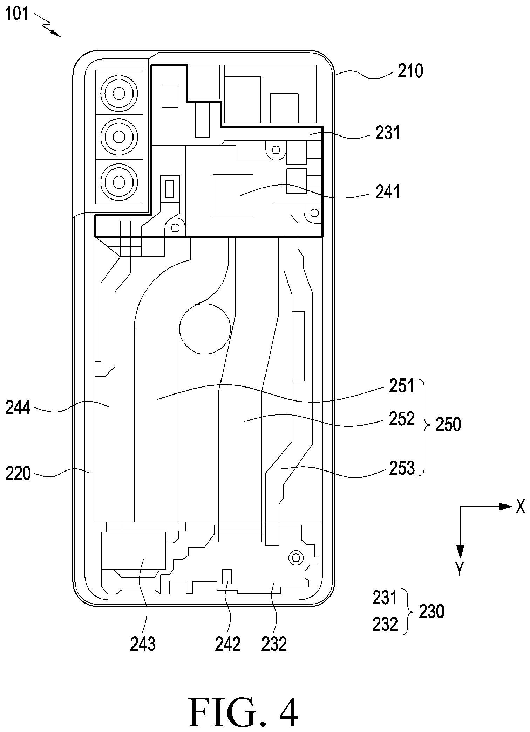

FIG. 4 is a view illustrating an arrangement relationship of a plurality of components inside an electronic device 101 according to various embodiments of the disclosure.

In FIG. 4 and subsequent drawings, a spatial coordinate system including the X axis, the Y axis substantially perpendicular to the X axis, and the Z axis substantially perpendicular to each of the X axis and the Y axis may be illustrated. According to various embodiments, the X axis of the spatial coordinate system may correspond to the width direction of the electronic device 101, the Y axis of the spatial coordinate system may correspond to the length direction of the electronic device 101, and the Z axis of the spatial coordinate system may correspond to the height direction of the electronic device 101.

The electronic device 101 may include a support member 220 disposed in the internal space surrounded by a housing 210, at least one board 230, and a plurality of electronic components 241, 242, 243, and 244.

According to an embodiment, the first support member 220 may be disposed inside the electronic device 200 to be connected to the side bezel structure (e.g., the side bezel structure 218 in FIG. 2), or may be configured integrally with the side bezel structure 218. According to an embodiment, the support member 220 may be in contact with the rear surface of a display (e.g., the display 201 in FIG. 2) and support at least a portion of the display 201. According to another embodiment, the support member 220 may include a rigid portion to support at least a portion of an electronic component (e.g., a battery 244) or at least a portion of at least one board 230. The support member 220 may be formed of, for example, a metal material and/or a non-metal (e.g., a polymer) material.

The at least one board 230 may include a printed circuit board. The printed circuit board may include a first printed circuit board 231 (e.g., a main printed circuit board) and a second printed circuit board 232 (e.g., an auxiliary printed circuit board). The board 230 according to an embodiment of the disclosure may be provided in a form in which several components are intensively assembled, that is, in the form of a printed circuit board assembly (PBA) (hereinafter, referred to as a "printed circuit board assembly"). For example, the first printed circuit board 231 may be configured as a printed circuit board assembly (PBA). In addition, the board 230 according to an embodiment of the disclosure may adopt a half printed circuit board (half PCB) structure in order to mount a larger capacity battery in an electronic device. For example, the first printed circuit board 231 may be configured in a half printed circuit board (half PCB) structure. In this case, the first printed circuit board 231 may be provided in a size corresponding to about half or less of the size of the display to be disposed at one side of the internal space of the housing 210, and a battery 244 may be disposed on substantially the same plane as the first printed circuit board 231 and adjacent to the first printed circuit board 231.

The second printed circuit board 232 may be disposed to be spaced apart from the first printed circuit board 231 in one direction (e.g., the length direction of the electronic device (the Y-axis direction)). In addition, the first printed circuit board 231 and the second printed circuit board 232 may be connected to each other via a connection member 250. The connection member 250 may include, for example, a board-to-board connector or a flexible printed circuit board (FPCB). According to various embodiments, at least one connection member 250 may be provided to interconnect the first printed circuit board 231 and the second printed circuit board 232. FIG. 4 illustrates first, second, and third connection members 251, 252, and 253 provided as the connection member 250, but other various embodiments may be applied.

On at least one board 230, i.e., the first printed circuit board 231 and the second printed circuit board 232, various electronic components 241, 242, 243, for example, a processor, a memory, and/or an interface may be mounted. According to an embodiment, the processor may include one or more of, for example, a central processing unit, an application processor, a graphics processor, an image signal processor, a sensor hub processor, or a communication processor. According to an embodiment, the memory may include, for example, a volatile memory or a nonvolatile memory. According to an embodiment, the interface may include, for example, a high-definition multimedia interface (HDMI), a universal serial bus (USB) interface, an SD card interface, and/or an audio interface. The interface may electrically or physically connect, for example, the electronic device 101 to an external electronic device and may include a USB connector, an SD card/an MMC connector, or an audio connector.

Hereinafter, a stacked PCB structure and PBA commonization will be described in detail focusing on the first printed circuit board 231 as the at least one board 230.

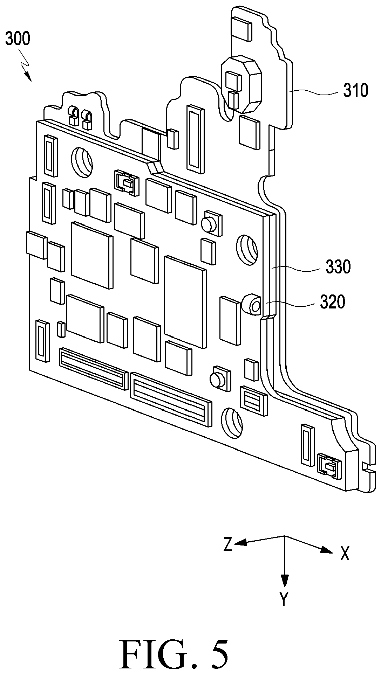

FIG. 5 is a view illustrating a printed circuit board assembly 300 according to some embodiments.

Referring to FIG. 5, the printed circuit board assembly 300 in FIG. 5 (e.g., the first printed circuit board 231 in FIG. 4) may be provided in the form of a half printed circuit board (half PCB), and the printed circuit board assembly 300 may provide a stacked PCB structure to secure a component mounting space. For example, the printed circuit board assembly 300 may include a first printed circuit board 310 (e.g., a primary PCB) on which a plurality of electronic components are mounted, and a second printed circuit board 320 (e.g., a secondary PCB) that at least partially overlap the first printed circuit board 310 and is electrically connected to the first printed circuit board 310.

According to an embodiment, the second printed circuit board 320 may be disposed to be spaced apart from the first printed circuit board 310 in the height direction (e.g., a direction parallel to the Z axis) by a predetermined distance. In addition, an interposer 330 may be disposed between the first printed circuit board 310 and the second printed circuit board 320 to electrically connect the two boards.

The printed circuit board assembly 300 illustrated in FIG. 5 may be manufactured through, for example, a high density interconnection (HDI) method and/or a package method (SAP) for thinning and miniaturization. Various electronic components may be mounted on the first printed circuit board 310 and the second printed circuit board 320. Among the electronic components mounted on the first printed circuit board 310 and/or the second printed circuit board 320, some electronic components may be disposed in the region between the first printed circuit board 310 and the second printed circuit board 320, and other electronic components may be mounted on one surface or the other surface of the second printed circuit board 320. By applying the stacked PCB structure as described above, even when the printed circuit board assembly 300 is configured in a half printed circuit board (half PCB) structure, a space for mounting the electronic components may be sufficiently secured.

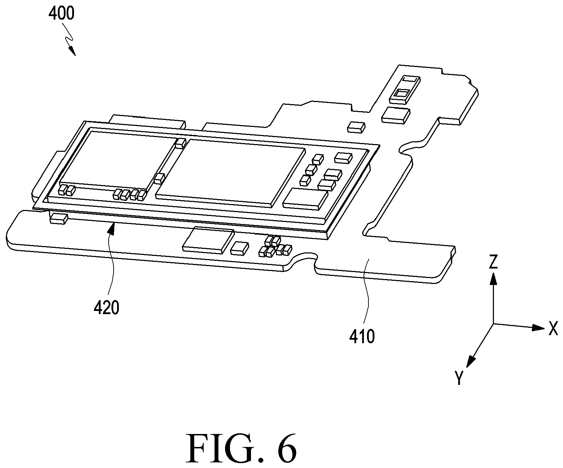

FIG. 6 is a view illustrating a printed circuit board assembly (PBA) 400 to which a communal printed circuit board module 420 is applied, according to various embodiments of the disclosure.

Referring to FIG. 6, a printed circuit board assembly 400 according to various embodiments of the disclosure may include a first printed circuit board 410 and a second printed circuit board 420, wherein the second printed circuit board 420 may be provided in the form of a communal (compatible) printed circuit board module.

Unlike the second printed circuit board 320 illustrated in FIG. 5, the communal printed circuit board module 420 illustrated in FIG. 6 may have a smaller size because the electronic components are intensively disposed thereon. As illustrated in the drawing, the communal printed circuit board module 420 may be manufactured to have, for example, a rectangular shape, and may be provided to be commonly applied to various types of electronic devices by being manufactured in a state in which specifications and standards are unified. According to an embodiment, the communal printed circuit board module 420 may be manufactured in the form of a module through miniaturization of a PCB and components by using a packaging method. The communal printed circuit board module 420 may be mounted with a processor as an electronic component. According to an embodiment, the processor may be mounted on one surface of the printed circuit board module 420 as a system-on-chip (SoC) or a system-in-package (SiP).

According to various embodiments, at least some of the electronic components of the communal printed circuit board module 420 may be surrounded by a shielding member. For example, a processor may be mounted on the communal printed circuit board module 420, and a shielding member for shielding electromagnetic waves may be provided around the processor to reduce external electromagnetic influence on the processor, or to prevent electromagnetic waves generated from the processor from acting as noise on other external electronic components.

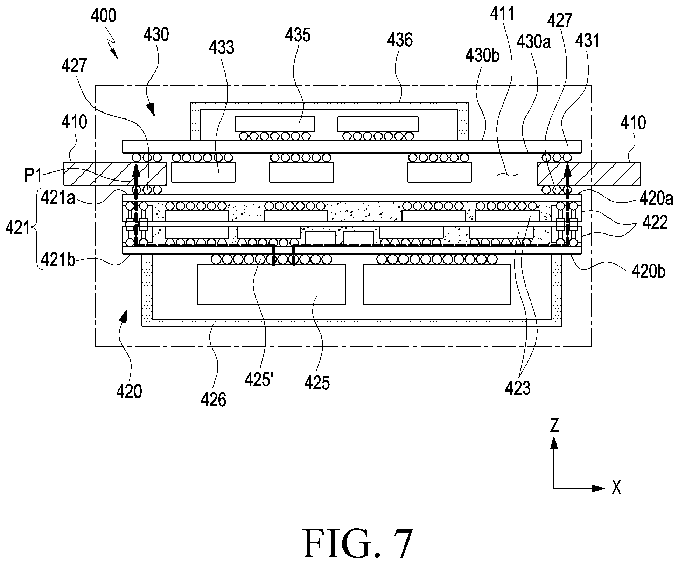

Hereinafter, the communal printed circuit board module 420 will be described in more detail with reference to the embodiments of FIGS. 7 to 13.

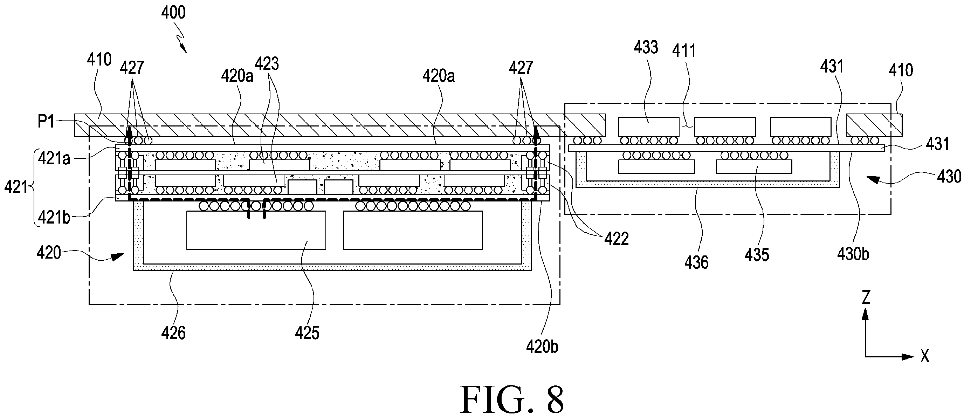

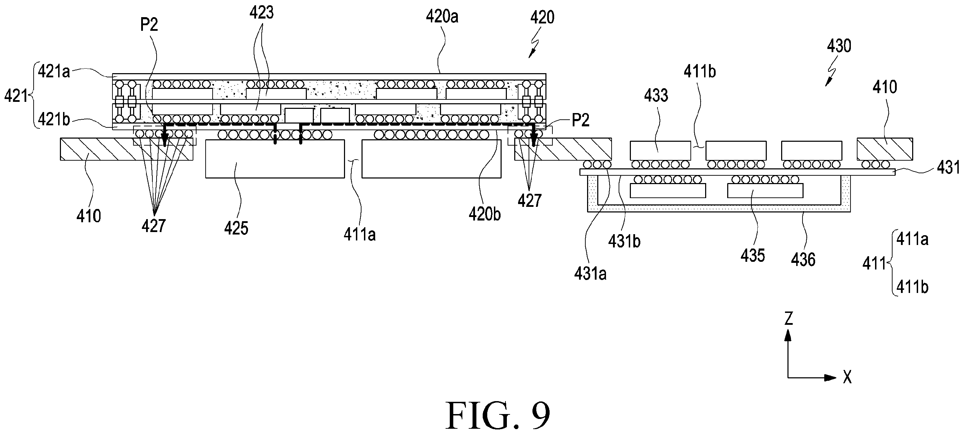

FIG. 7 is a view illustrating a printed circuit board assembly 400 including at least one printed circuit board module according to an embodiment of the disclosure. FIG. 8 is a view illustrating a printed circuit board assembly 400 including at least one printed circuit board module according to another embodiment of the disclosure. FIG. 9 is a view illustrating a printed circuit board assembly 400 including at least one printed circuit board module according to still another embodiment of the disclosure.

As illustrated in FIGS. 7 to 9, the printed circuit board assembly 400 may be configured by disposing a plurality of printed circuit board modules 420 and 430 in various shapes. Some or all of the plurality of printed circuit board modules provided in the printed circuit board assembly 400 may be a communal printed circuit board module 420. As an example, the embodiments of FIGS. 7 to 9 illustrate the state in which a communal printed circuit board module 420 and a non-communal printed circuit board module 430 are coupled to each other.

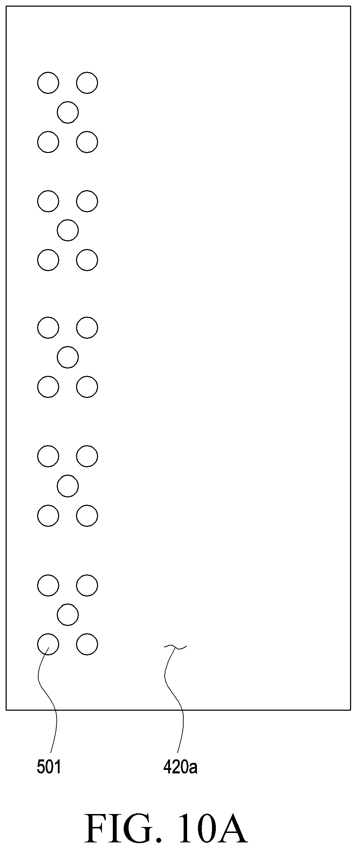

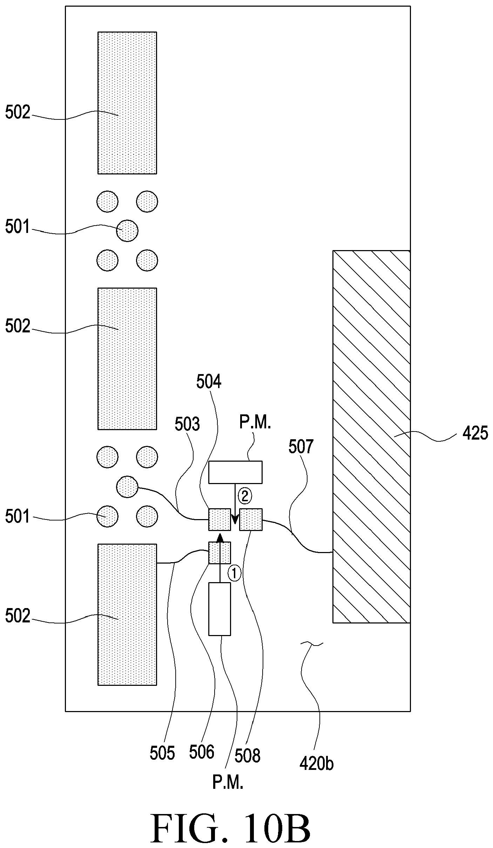

The communal printed circuit board module 420 may include a board 421 including a first surface 420a and a second surface 420b and at least one component 425. According to an embodiment, the first surface 420a may be oriented in a first direction (e.g., the Z-axis direction), and may be provided with a first pad (e.g., the first pad 501 in FIG. 10A to be described later) to be electrically connected to another board (e.g., the first printed circuit board 410 in FIGS. 7 and 8). The second surface 420b may be oriented in a second direction opposite to the first direction, and may be provided with a first pad (e.g., the first pad 501 in FIG. 10B to be described later) for electrical connection to the other board 410 (e.g., the first printed circuit board 410 in FIG. 9) and a second pad (e.g., the second pad 502 of FIG. 10B to be described later) for bonding the shielding member 426. In an embodiment, the second surface 420b may be provided with a pad 425' oriented in the second direction opposite to the first direction for electrical connection to at least one component 425. For example, the at least one component 425 may be disposed on the second surface 420b. In various embodiments of the disclosure, the type and shape of the at least one component 425 are not limited to any particular one. The at least one component 425 may include, for example, a communication device, a processor, a memory, a wireless communication circuit and/or an interface. The processor may include, for example, one or more of a central processing unit, an application processor, a graphics processing unit, an image signal processor, a sensor hub processor, or a communication processor. According to an embodiment, the processor may have a configuration in which at least a communication processor is included or an application processor and a communication processor are integrated, and may control or drive the wireless transceiver, the power management module, or the wireless communication circuit. The at least one component may include a plurality of electronic components or elements for implementing at least one function.

According to various embodiments, the communal printed circuit board module 420 may have a stacked PCB structure in which a plurality of components are separately disposed on different layers. For example, in the communal printed circuit board module 420, at least one electronic component may be disposed on each of one surface and the other surface of the board. In an embodiment, the stacked PCB structure may include a first board 421a and a second board 421b. The first board 421a and the second board 421b provide the first surface 420a and the second surface 420b, respectively, wherein an internal space may be defined between the first board 421a and the second board 421b. In addition, in the internal space, a plurality of electronic components may be disposed in addition to or in replacement of the at least one component 425 described above.

At least one interposer (or an interposer connector) 422 may be disposed between the first board 421a and the second board 421b. For example, the interposer 422 may be that obtained by packaging a terminal part for electrical connection between boards with an insulating material (e.g., silicon (Si), glass, or ceramic), the outside of which is coated with a shielding material (e.g., a plating layer) to improve the shielding performance. The first board 421a and the second board 421b may be provided to be spaced apart by a predetermined distance in the height direction (e.g., the Z-axis direction) via the interposer 422. According to an embodiment, by providing a stacked PCB structure using the interposer 422, it is possible to effectively use an insufficient arrangement space inside the electronic device. According to an embodiment, it is possible to provide a double-sided arrangement electronic component module for improving space availability, component arrangement, and/or space arrangement efficiency of the electronic device by using the first board 421a, the second board 421b, and the interposer 422.

The type and shape of at least one component 423 disposed in the internal space between the first board 421a and the second board 421b are not limited to any specific embodiment. For example, the at least one component 423 may include a radio frequency front end (RFFE), a radio frequency transceiver (RF transceiver), a power management module, and/or a logic circuit.

The electronic components 423 and 425 may be disposed on the first board 421a and/or the second board 421b via contacts implemented in a type such as a ball grid array (BGA) or a land grid array (LGA) and may be electrically connected to each other. Various methods for protecting the electronic components 423 and 425 from external electromagnetic influences and/or impacts may be provided. For example, a shielding member 426 (e.g., a shield can) may be disposed to surround the periphery of the electronic component 425 disposed on the second surface 420b to protect the electronic component 425 from electromagnetic effects of other electronic components or to minimizing electromagnetic effects on other electronic components. Furthermore, in addition to or in replacement of the shielding member (not illustrated), a molded portion provided by curing a plastic resin molten for stable arrangement on the board may be provided around the electronic component 423 disposed between the first board 421a and the second board 421b.

Summarizing the above description, the communal printed circuit board module 420 is a communal printed circuit board module, and may be provided in a stacked PCB structure including a plurality of electronic components.

This communal printed circuit board module 420 may provide the printed circuit board assembly 400 together with other printed circuit board modules (e.g., the non-communal printed circuit board module 430).

According to various embodiments, similar to the communal printed circuit board 420, the non-communal printed circuit board module 430 may include a board 431 having one surface 430a and the other surface 430b and electronic components 433 and 435 disposed on the one surface 430a and/or the other surface 430b of the board 431, and a shielding member 436 for protecting at least some of the electronic components 435 from external electromagnetic influences. However, it may be assumed that, unlike the communal printed circuit board module 420, the non-communal printed circuit board module 430 is capable of being mounted only in a specific electronic device and is not compatible with other electronic devices.

Referring to FIGS. 7 to 9 together, the communal printed circuit board module 420 may be mounted on the first printed circuit board 410 of the printed circuit board assembly 400 together with the non-communal printed circuit board module 430 in various forms according to embodiments. As described above in the section of "Technical Problem", various embodiments of the disclosure may provide a printed circuit board assembly that enables a printed circuit board to be communal and enables the area as well as the height of the printed circuit board to be reduced. Accordingly, a method of reducing the height of a printed circuit board may be described in detail based on each of the embodiments illustrated in FIGS. 7 to 9.

First, referring to FIG. 7, the communal printed circuit board module 420 may be provided in a stacked form in the height direction (e.g., the Z-axis direction) together with the non-communal printed circuit board module 430. According to an embodiment, at least one opening 411 may be provided in the first printed circuit board 410, and at least a portion of the non-communal printed circuit board module 430 (e.g., the electronic components 433) may be accommodated in the opening 411. The opening 411 may be provided by cutting the first printed circuit board 410 to be suitable for the size of a component to be mounted on the same. According to the embodiment illustrated in FIG. 7, in configuring the printed circuit board assembly 400 by using the two printed circuit board modules 420 and 430, it is possible to reduce the overall height of the printed circuit board assembly 400 as much as the printed circuit board assembly 400 is accommodated in the opening 411.

Next, referring to FIG. 8, the communal printed circuit board module 420 may be disposed together with the non-communal printed circuit board module 430 side by side in the width direction of the electronic device (e.g., the X-axis direction). According to an embodiment, at least one opening 411 may be provided in the first printed circuit board 410, and at least a portion of the non-communal printed circuit board module 430 (e.g., the electronic components 433) may be accommodated in the opening 411. According to the embodiment illustrated in FIG. 8, it can be identified that the overall height of the printed circuit board assembly 400 is further reduced compared to the embodiment illustrated in FIG. 7.

Next, referring to FIG. 9, the communal printed circuit board module 420 may be disposed together with the non-communal printed circuit board module 430 side by side in the width direction of the electronic device (e.g., the X-axis direction). According to an embodiment, at least two openings 411a and 411b may be provided in the first printed circuit board 410, and at least a portion of the communal printed circuit board module 420 (e.g., the electronic components 425) and at least a portion of the non-communal printed circuit module 430 (e.g., the electronic components 433) may be accommodated in the at least two openings 411a and 411b, respectively. According to the embodiment illustrated in FIG. 9, it can be identified that the overall height of the printed circuit board assembly 400 can be further reduced compared to the embodiments illustrated in FIGS. 7 and 8.

In the embodiments illustrated in FIGS. 7 to 8, the communal printed circuit board module 420 may provide a first electrical connection path P1 by contacts 427 (e.g., solder) provided between the first printed circuit board 410 and the communal printed circuit board module 420. As will be described later with reference to the drawing of FIG. 10A, the contacts 427 illustrated in FIGS. 7 and 8 are provided on first pads (e.g., the first pads 501 in FIG. 10A) on the first surface 420a. Unlike this, in the embodiment illustrated in FIG. 9, the communal printed circuit board module 420 may provide a second electrical connection path P2 by contacts 427 provided between the communal printed circuit board module 420 and the first printed circuit board module 420. As will be described later with reference to the drawing of FIG. 10B, the contacts 427 illustrated in FIG. 9 may be formed on first pads (e.g., the first pads 501 in FIG. 10B) on the second surface 420b. In this way, the communal printed circuit board module 420 may provide electrical connection paths in opposite directions depending on how it is disposed in relation to the first printed circuit board 410 and the non-communal printed circuit board module 430. That is, the communal printed circuit board module 420 may provide electrical connection paths in both directions of one direction and another direction opposite to the one direction (hereinafter referred to as "both directions") depending on how the communal printed circuit board module 420 is disposed.

In order to provide electrical connection paths in both directions, the communal printed circuit board module 420 may provide an electrical contact structure different from that of the non-communal printed circuit board module 430. Hereinafter, the electrical contact structure of the printed circuit board module 420 will be described in detail with reference to the embodiments of FIGS. 10A to 13.

The embodiments described with reference to FIGS. 7 to 9 illustrate the communal printed circuit board module 420 and the non-communal printed circuit board module 430 in the state of being combined together, but the disclosure is not necessarily limited thereto. For example, even when the printed circuit board assembly 400 is configured by using two communal printed circuit board modules 420, the above-described embodiments may be applied.

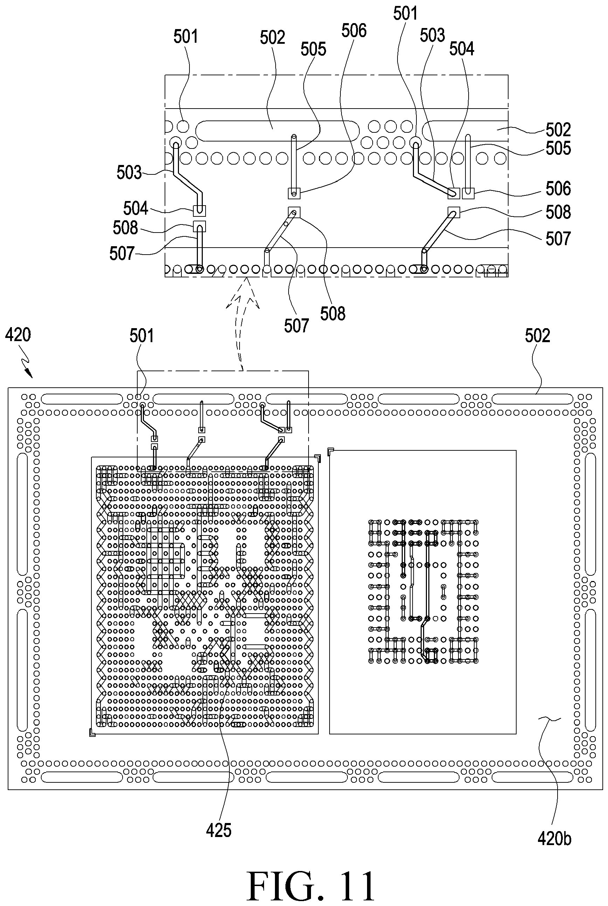

FIG. 10A is a view illustrating a first surface 420a of a communal printed circuit board module 420 according to various embodiments of the disclosure. FIG. 10B is a view illustrating a second surface 420b of a communal printed circuit board module 420 according to various embodiments of the disclosure. FIG. 11 is a view illustrating a third pad, a fourth pad, and a fifth pad provided on the second surface 420b of the printed circuit board module 420 according to various embodiments of the disclosure.

Referring to FIGS. 10A and 10B, according to various embodiments, the first surface 420a of the communal printed circuit board module 420 may be provided with a first pad 501 for electrical connection with another board (e.g., the first printed circuit board 410 in FIG. 7), and the second surface 420b may be provided with a first pad 501 for electrical connection to another board (e.g., the first printed circuit board 410 in FIG. 9) and the second pads 502 for bonding a shielding member. According to an embodiment, the first pad 501 may be provided in the form of a ball pad, and the second pad 502 may be provided in a pad shape relatively wider and longer than the ball pad, for example, may be provided a shield can pad shape.

According to various embodiments of the disclosure, in the communal printed circuit board module 420, of the first surface 420a and the second surface 420b, for example, an electronic component 425 that emits a large amount of electromagnetic noise may be disposed, such as a processor, may be disposed on the second surface 420b. Accordingly, the first surface 420a may be a surface that provides contact points with the first printed circuit board 410 in a normal situation (e.g., an embodiment in which it is not necessary to significantly reduce the height as in the embodiments of FIGS. 7 and 8). Accordingly, the first pads 501 for electrical connection to the board 410 may be provided on the first surface 420a. A plurality of first pads 501 may be provided and may extend along an edge of the first surface 420a. In contrast, since it is necessary to provide a shielding member 426 (e.g., a shield can) on the second surface 420b to electrically shield the electronic component 425 that emits a large amount of noise, a second pad 502 may be included for bonding the shielding member.

According to various embodiments, for application of the embodiment described above with reference to FIG. 9, the second surface 420b may further include a first pad 501 as well as a second pad 502. By including the first pad 501 on the second surface 420b as well, the second surface 420b may be bonded to a board 410.

Referring to FIG. 10B, a plurality of first pads 501 and a plurality of second pads 502 may be alternately disposed along an edge of the second surface 420b. In addition, each of the first pads 501 and the second pads 502 may be disposed to surround at least a portion of the periphery of the at least one component 425 in a state of being spaced apart from the at least one component 425 by a predetermined distance.

Referring to FIGS. 10B and 11 together, the communal printed circuit board module 420 may further include, on the second surface 420b, a third pad 504 electrically connected to the first pad 501 via a conductive wire 503, a fourth pad 506 electrically connected to the second pad 502 via a conductive wire 505, and a fifth pad 508 electrically connected to the at least one component 425 via a conductive wire 507.

According to various embodiments, the third pad 504 may be a metal mask portion extending from the first pad 501 toward the at least one component 425, and the fourth pad 506 may be a metal mask portion extending from the second pad 502 toward the at least one component 425. In addition, the fifth pad 508 may be a metal mask portion extending toward the first pad 501 or the second pad 502 from some of the plurality of contact points formed under the at least one component 425.

According to an embodiment, when the communal printed circuit board module 420 is bonded to a board (e.g., the first printed circuit board 410 in FIG. 7) via the first surface 420a, a shielding member (e.g., the shielding member 426 in FIG. 7) may be bonded to the second pad 502 of the second surface 420b. In this case, a first paste metal (PM) that interconnects the third pad 504 and the fourth pad 506 may be provided. Referring to FIG. 10B, the paste metal is a pigment made into a paste state by mixing metallic powders of silver, aluminum, gold, lead, or the like and a binder in a resin solution. In the disclosure, the paste metal may serve to electrically interconnect different pads that are not electrically connected to each other. According to an embodiment, the first paste metal may be provided by being applied in a direction ① to cover the third pad 504 and the fourth pad 506 and then cured. According to an embodiment, since the shielding member (e.g., the shielding member 426 in FIG. 7) (e.g., the shield can) is connected to a ground, when the third pad 504 and the fourth pad 506 are connected to each other via a first paste metal, the first pad 501 may also be connected to the ground. That is, the second pad 502 and the first pad 501 may be connected together to the ground, which may have an effect of substantially expanding the area of the second pad 502. Through this, when the shielding member 426 is bonded to the second pad 502, it is possible to increase the mountable area compared to the conventional one, and from the viewpoint of signal transmission of a circuit, it may also possible to reduce a loss by preventing.

In addition, according to an embodiment, when the communal printed circuit board module 420 is bonded to a board 410 (e.g., the first printed circuit board 410 in FIG. 9) via the second surface 420b, a second paste metal (PM) interconnecting the third pad 504 and the fifth pad 508 may be provided. According to an embodiment, the second paste meta may be provided by being applied in a direction ② to cover the third pad 504 and the fifth pad 506 and then cured. As the third pad 504 and the fifth pad 508 are connected to each other, the first pad 501 may be used as a portion of an electrical connection path extending from the at least one component 425 (e.g., the electrical connection path P2 in FIG. 9). For example, when the communal printed circuit board module 420 is bonded to the board (e.g., the first printed circuit board 410 in FIG. 9) via the second surface 420b, the first pad 501 portion provided on the second surface 420b is bonded so that the first printed circuit board 410 and the communal printed circuit board module 420 can be connected to each other.

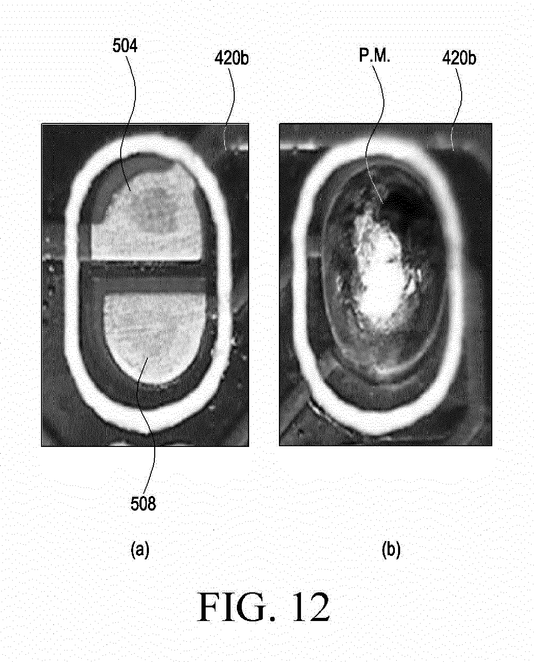

FIGS. 12A and 12B are views each illustrating a paste metal according to various embodiments of the disclosure.

FIG. 12A illustrates a state in which the third pad 504 and the fifth pad 508 are electrically disconnected from each other. FIG. 12B illustrates a state in which a paste metal PM (e.g., a second paste metal) is applied and then cured in FIG. 12A.

As illustrated in FIGS. 12 A and B, in the disclosure, when the communal printed circuit board module 420 is bonded to the board 410 via the second surface 420b, it is possible to electrically interconnect the third pad 504 and the fifth pad 508 by covering the space between the third pad 504 and the fifth pad 508 with the second paste metal.

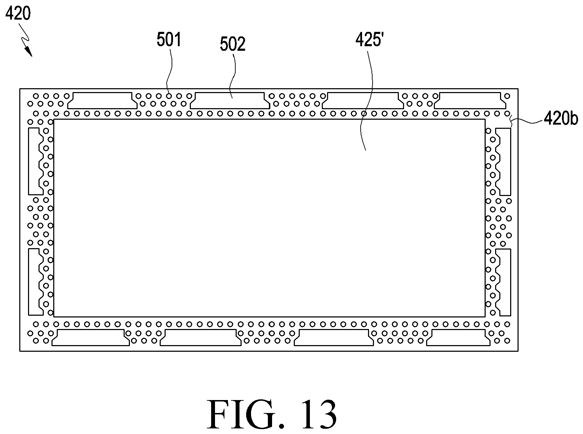

FIG. 13 is a view illustrating a communal printed circuit board module 420 according to another embodiment of the disclosure.

The shapes of a first pad 501 and a second pad 502 provided in the common printed circuit board module 420 may vary according to each embodiment. According to an embodiment, as described above with reference to FIGS. 10A to 11, the first pad 501 and the second pad 502 surround at least a portion of the periphery of at least one component while being spaced apart from the at least one component, and the third pad 504, the fourth pad 506, and the fifth pad 508 and conductive wires 503, 505, and 507 interconnecting the pads may be provided in the region between the first and second pads and the at least one component. However, the disclosure is not necessarily limited thereto, and according to another embodiment, as illustrated in FIG. 13, a mode in which a plurality of first pads 501 and a plurality of second pads are densely arranged along the periphery of a region 425' in which at least one component is mounted without including a separate region (e.g., an empty region in which no pad is provided) between the first and second pads and the at least one component is also applicable.

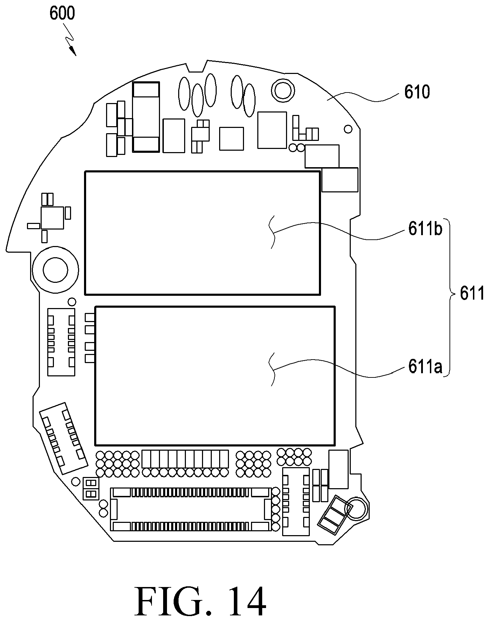

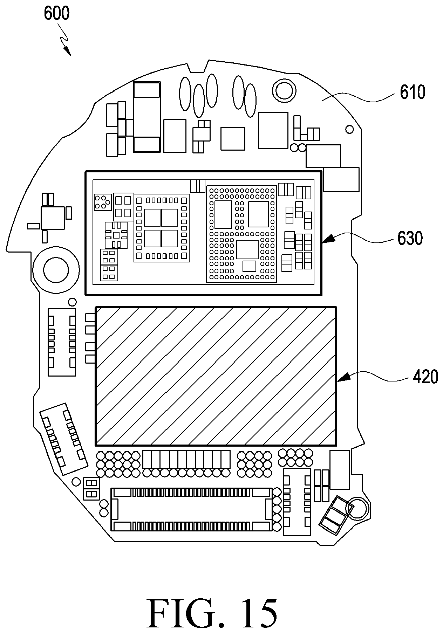

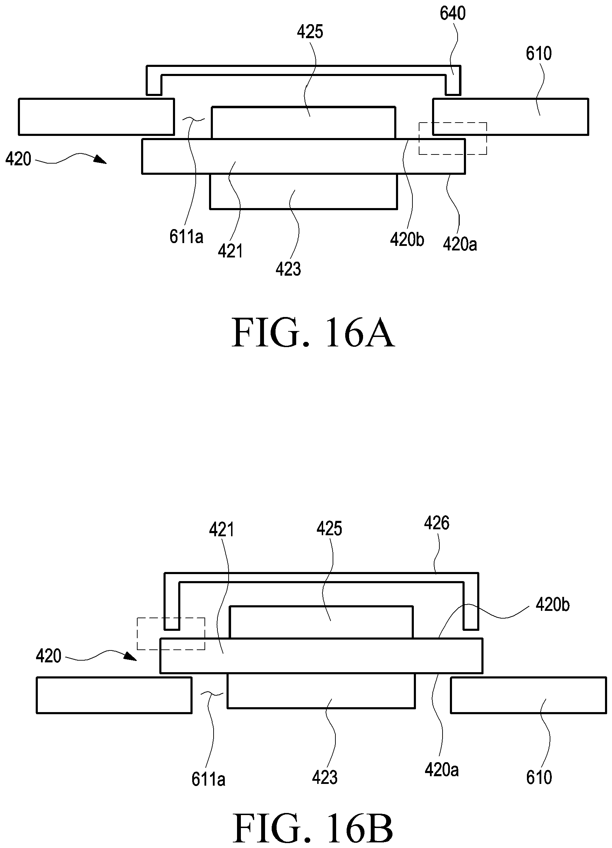

FIG. 14 is a view illustrating a board of an electronic device according to another embodiment. FIG. 15 is a view illustrating a state in which a communal printed circuit board module 420 is disposed on a board of an electronic device according to another embodiment. FIG. 16A is a view illustrating a method of disposing a communal printed circuit board module 420 in an opening, according to an embodiment. FIG. 16B is a view illustrating a method of disposing a communal printed circuit board module 420 in an opening, according to an embodiment different from that of FIG. 16A.

An electronic device according to various embodiments disclosed herein may be any of various types of devices. The electronic device may include, for example, a portable communication device (e.g., a smartphone), a computer device, a portable multimedia device, a portable medical device, a camera, a wearable device, or a home appliance. The electronic device according to an embodiment disclosed herein is not limited to the above-described devices.

For example, as an electronic device different from the terminal-type electronic device 101 described with reference to FIGS. 2 and 3, the disclosure is applicable to a wearable device 600 illustrated in FIG. 14. The embodiment illustrated in 14 and 15 may illustrate, for example, a board 610 of a wireless earphone as a wearable device.

At least one printed circuit board module may be disposed on the board 610 together with at least one component. According to various embodiments, at least one opening 611 may be provided in the board 610 to accommodate at least a portion of the printed circuit board module in order to increase a component mounting space. For example, in FIG. 14, a first opening 611a and a second opening 611b may be provided side by side in the board. As illustrated in FIG. 15, a printed circuit board module may be disposed in each of the first opening 611a and the second opening 611b. For example, a module 630 capable of performing a function specific to a wearable device 600 (e.g., active noise canceling (ANC)) (e.g., a speaker module) may be disposed in one opening (e.g., the second opening 611b), and the communal printed circuit board module 420 described with reference to the embodiments of FIGS. 6 to 13 may be disposed in the other opening (e.g., the first opening 611a). In describing the communal printed circuit board module 420, a description overlapping that of the above-described embodiment may be omitted.

Referring to FIGS. 16A and 16B together, a communal printed circuit board module 420 mountable in the first opening 611a of the board 610 may include a board 421 including a first surface 420a and a second surface 420b. In addition, an electronic component 423 disposed on the first surface 420a of the board 421 and an electronic component 425 disposed on the second surface 420b may be included, wherein the electronic component 425 disposed on the second surface 420b may a component that generates a relatively large amount of electromagnetic noise, such as a processor. Accordingly, the communal printed circuit board module 420 may further include a shielding member 426 for shielding the electronic component 425. According to an embodiment, as illustrated in FIG. 16A, the printed circuit board module 420 may be bonded to the board 610 via the first surface 420a. In this case, the shielding member 426 may be disposed on and bonded to the second surface 420b. According to another embodiment, as illustrated in FIG. 16B, the printed circuit board module 420 may be bonded to the board 610 via the second surface 420b. In this case, instead of the shielding member 426, the board 610 may be disposed on and bonded to the second surface 420b. According to an embodiment, an electromagnetic wave may be shielded by providing a shielding member 640 that may be coupled to one surface of the board 610 instead of the second surface 420b of the printed circuit board module 420.

In this way, a communal printed circuit board module 420 may be applicable to various types of electronic devices. When the communal printed circuit board module 420 provided in the disclosure is applied to a printed circuit board assembly including an opening provided through cutout, it is possible to miniaturize the printed circuit board assembly and the electronic device including the same in terms of thickness.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, it is possible to provide a printed circuit board module (e.g., the printed circuit board module 420 in FIG. 7) including: a board (e.g., the substrate 421 in FIG. 7) that includes: a first surface (e.g., the first surface 420a in FIG. 7) oriented in a first direction and provided with a first pad (e.g., the first pad 501 in FIG. 10A) to be electrically connected to another board (e.g., the first printed circuit board 410 in FIG. 9); and a second surface (e.g., the second surface 420b in FIG. 7) oriented in a second direction opposite to the first direction and provided with a first pad (e.g., the first pad 501 in FIG. 10b) for electrical connection with the another board (e.g., the first printed circuit board 410 in FIG. 9) and a second pad (e.g., the second pad 502 in FIG. 10B) to which a shielding member (e.g., the shielding member 426 in FIG. 7) is to be bonded; and at least one component (e.g., the component 425 in FIG. 7) disposed on the second surface, wherein the printed circuit board module is capable of being bonded to the another board adjacent thereto by using the first pad provided on the first surface or the second surface.

According to various embodiments, the printed circuit board module may have a stacked PCB structure in which a plurality of components are separately disposed on different layers.

According to various embodiments, the board may include: a first board (e.g., the first board 421a in FIG. 7) that provides the first surface; and a second board (e.g., the second board 421b in FIG. 7) that provides the second surface and defines an internal space with the first board.

According to various embodiments, the first board and the second board may be connected to each other via an interposer (e.g., the interposer 422 in FIG. 7).

According to various embodiments, the electronic device may further include at least one component (e.g., the component 423 in FIG. 7) in a space between the first board and the second board.

According to various embodiments, the at least one component may include a processor.

According to various embodiments, a plurality of the first pads and a plurality of second pads may be alternately disposed along an edge of the second surface.

According to various embodiments, each of the first pad and the second pad may be disposed to surround at least a portion of a periphery of the at least one component while being spaced apart from the at least one component by a predetermined distance.

According to various embodiments, the electronic device may further include, on the second surface, a third pad (e.g., the third pad 504 in FIG. 10B) electrically connected to the first pad via a conductive wire, a fourth pad (e.g., the fourth pad 506 in FIG. 10B) electrically connected to the second pad via a conductive wire, and a fifth pad (e.g., the fifth pad 508 in FIG. 10B) electrically connected to the at least one component via a conductive wire.

According to various embodiments, when the printed circuit board module (e.g., the printed circuit board module 420 in FIG. 7) is bonded to the another board via the first surface (e.g., the embodiment of FIGS. 7 and 8), a shielding member is bonded to the second pad of the second surface, and the printed circuit board module is provided with a first paste metal (e.g., the PM provided in the direction ① in FIG. 10B) that interconnects the third pad and the fourth pad.

According to various embodiments, when the printed circuit board module (e.g., the printed circuit board module 420 in FIG. 7) is bonded to the another board via the second surface (e.g., the embodiment of FIG. 9), the printed circuit board module is provided with a second paste metal (e.g., the PM provided in the direction ② in FIG. 10B) that interconnects the third pad and the fifth pad.

According to various embodiments, it is possible to provide an electronic device (e.g., the electronic device 101 in FIG. 2 or the wearable device 600 in FIG. 4) including: a housing; a board disposed inside the housing and including at least one opening; and a printed circuit board module including a first surface which is oriented in a first direction and a second surface which faces away from the first surface and on which at least one component is disposed, the printed circuit board module being disposed on the board in a state of being at least partially accommodated in the opening, wherein the printed circuit module is provided with pads on the first surface and the second surface such that the printed circuit board module is capable of being selectively bonded to the board via the first surface or the second surface.

According to various embodiments, the first surface of the printed circuit board module may be provided with a first pad for electrical connection to the board.

According to various embodiments, the second surface of the printed circuit board module may be provided with a first pad to be electrically connected to the board and a second pad to bond a shielding member thereto.

According to various embodiments, a plurality of first pads and a plurality of second pads may be alternately disposed on the second surface.

According to various embodiments, each of the first pad and the second pad may be disposed to surround at least a portion of a periphery of the at least one component while being spaced apart from the second component by a predetermined distance.

According to various embodiments, the electronic element may further include, on the second surface, a third pad electrically connected to the first pad via a conductive wire, a fourth pad electrically connected to the second pad via a conductive wire, and a fifth pad electrically connected to the at least one component via a conductive wire.

According to various embodiments, when the printed circuit board module is bonded to the board via the first surface, a shielding member may be bonded to the second pad of the second surface, and the printed circuit board module may be provided with a first paste metal that interconnects the third pad and the fourth pad.

According to various embodiments, when the printed circuit board module is bonded to the board via the second surface, the printed circuit board module may be provided with a second paste metal that interconnects the third pad and the fifth pad.

According to various embodiments, the at least one component may include a processor.

It may be apparent to a person ordinarily skilled in the technical field to which the disclosure belongs that a method of manufacturing the above-mentioned electronic device and electronic device housing structure according to various embodiments disclosed herein is not limited by the above-mentioned embodiments and drawings, and may be variously substituted, modified, and changed within the technical scope disclosed herein.

## Claims

1. A printed circuit board module comprising:
a board that includes:
a first surface oriented in a first direction and provided with a first pad to be electrically connected to another board; and
a second surface oriented in a second direction opposite to the first direction and provided with a first pad for electrical connection with the another board and a second pad to which a shielding member is to be bonded; and
at least one component disposed on the second surface,
wherein the printed circuit board module is capable of being bonded to the another board adjacent thereto by using the first pad provided on the first surface or the second surface.

2. The printed circuit board module of claim 1, wherein the printed circuit board module has a stacked PCB structure in which a plurality of components are separately disposed on different layers.

3. The printed circuit board module of claim 2, wherein the board includes:
a first board that provides the first surface; and
a second board that provides the second surface and defines an internal space with the first board.

4. The printed circuit board module of claim 4, wherein the first board and the second board are connected to each other via an interposer.

5. The printed circuit board module of claim 4, further comprising:
at least one component in the space between the first board and the second board.

6. The printed circuit board module of claim 1, wherein the at least one component includes a processor.

7. The printed circuit board module of claim 1, wherein a plurality of the first pads and a plurality of second pads are alternately disposed along an edge of the second surface.

8. The printed circuit board module of claim 1, wherein each of the first pad and the second pad is disposed to surround at least a portion of a periphery of the at least one component while being spaced apart from the at least one component by a predetermined distance.

9. The printed circuit board module of claim 8, further comprising:
on the second surface,
a third pad electrically connected to the first pad via a conductive wire;
a fourth pad electrically connected to the second pad via a conductive wire; and
a fifth pad electrically connected to the at least one component via a conductive wire.

10. The printed circuit board module of claim 9, wherein, when the printed circuit board module is bonded to the another board via the first surface, a shielding member is bonded to the second pad of the second surface, and the printed circuit board module is provided with a first paste metal that interconnects the third pad and the fourth pad.

11. The printed circuit board module of claim 9, wherein, when the printed circuit board module is bonded to the another board via the second surface, the printed circuit board module is provided with a second paste metal that interconnects the third pad and the fifth pad.

12. The electronic device comprising the printed circuit board module of any one of claims 1 to 11.

13. The electronic device of claim 12, further comprising :
a board disposed in a housing and including at least one opening.

14. The electronic device of claim 13, wherein the printed circuit board is capable of being disposed on the board in a state of being at least partially accommodated in the at least one opening.

15. The electronic device of claim 13 or 14, wherein the printed circuit board is capable of being selectively bonded to the board via the first surface or the second surface.
